# EUROPÄISCHE PATENTSCHRIFT

(11) **EP 0 924 778 B1**
(45) Veröffentlichungstag und Bekanntmachung des Hinweises auf die Patenterteilung: **26.11.2008**
(21) Anmeldenummer: 98204258.2
(22) Anmeldetag: 15.12.1998
(51) Int. Cl.: H01L 41/09, B26B 19/28

(54) **Antriebsvorrichtung für drei Rotationselemente mit wenigstens zwei piezoelektrischen Antriebselementen**
Driving device for three rotary elements with at least two piezoelectric actuators
Dispositif de propulsion pour trois éléments de rotation avec au moins deux organes d'entraînement à type piézoélectrique

(30) Priorität: 20.12.1997 DE 19757139
(43) Veröffentlichungstag der Anmeldung: 23.06.1999
(73) Patentinhaber: Philips Intellectual Property & Standards GmbH, 20099 Hamburg (DE); Koninklijke Philips Electronics N.V., 5621 BA Eindhoven (NL)
(72) Erfinder: Diefenbach, Gerhard, Röntgenstrasse 24, 22335 Hamburg (DE); Reichinger, Christian, Dr., Röntgenstrasse 24, 22335 Hamburg (DE); Wendt, Matthias, Dr., Röntgenstrasse 24, 22335 Hamburg (DE)
(74) Vertreter: Damen, Daniel Martijn

(56) Entgegenhaltungen:
- EP-A- 0 712 170
- WO-A-99/31740
- DE-A- 2 530 045
- US-A- 4 882 500
- PATENT ABSTRACTS OF JAPAN vol. 013, no. 168 (E-747), 21. April 1989 (1989-04-21) & JP 64 001481 A (KYOCERA CORP), 5. Januar 1989 (1989-01-05)

## Beschreibung

Die Erfindung bezieht sich auf eine Antriebsvorrichtung mit einem ersten Rotationselement, einem zweiten Rotationselement und einem dritten Rotationselement, die dreieckförmig angeordnet sind, wobei zwischen dem ersten Rotationselement und dem zweiten Rotationselement ein erstes piezoelektrisches Antriebselement angeordnet und mittels einer Vorspannkraft eingespannt ist, das einen piezoelektrischen Resonator und wenigstens zwei an dem piezoelektrischen Resonator angeordnete und einander gegenüberliegende Reibelemente aufweist, wobei jeweils eines der Reibelemente des ersten Antriebselementes gegen jeweils das erste oder das zweite Rotationselement drückt, und wobei elektrische Mittel zum Anregen einer Schwingung des piezoelektrischen Resonators vorgesehen sind.

Eine derartige Antriebsvorrichtung ist beispielsweise aus der DE 25 30 045 bekannt. Diese bekannte Antriebsvorrichtung für drei Rotationselemente weist ein piezoelektrisches Antriebselement mit einem piezoelektrischen Resonator auf. Die an dem Resonator einander gegenüberliegend angeordneten mechanischen Kontaktflächen des Resonators bilden zwei Reibelemente. Der Resonator ist zwischen zwei der drei Rotationselementen angeordnet und mittels einer Vorspannkraft zwischen diese zwei Rotationselemente eingespannt, wobei jeweils eines der zwei Reibelemente gegen jeweils eines dieser zwei Rotationselemente drückt. Das dritte Rotationselement wird in einem Mittelbereich des Antriebselementes gegen eine Hauptseitenfläche des Resonators gedrückt.

Aus der DE 35 00 607 C2 ist eine Antriebsvorrichtung bekannt, die piezoelektrische Dickenschwinger aufweist, deren Dickenschwingungen mit Hilfe eines Torsionskopplers in Torsionsschwingungen eines Torsionsresonators überführt werden. Eine derartige Anordnung hat einen geringen Wirkungsgrad, da das aktive Piezovolumen wesentlich kleiner is als das Volumen des anzuregenden Torsionsresonators. Der Achsabstand zwischen den einzelnen Rotationselementen ist bei deser bekannten Antriebsvorrichtung durch die Abmessungen des Torsionsresonators bestimmt. Eine Drehrichtungsumkehr ist nur möglich, wenn die Motoreinheit relativ zu den Achsen verschoben wird.

Das US Patent 4,882,500 offenbart eine Antriebsvorrichtung mit einem Vibrator und einem elastischen Element in dem der Vibrator im Betrieb eine stehende Welle generiert. Das elastische Element ist eine Stange aus Bronze. An zwei gegenüber liegenden Seiten dieser Stange wird jeweils eine Laufrolle angedrückt. Wenn in der Stange eine stehende Welle generiert wird, werden die Laufrollen von der Welle in Drehung gebracht, so dass die Laufrollen über die Stange abrollen.

Die JP-A-64-1481 offenbart eine Antriebsvorrichtung mit einer Anzahl von Rotationselementen, die mit einander in Angriff sind. Diese Antriebsvorrichtung hat einen piezoelektrischen Resonator, der über ein Zwischenteil in Form einer Stimmgabel die Rotationselemente antreiben kann. Das Zwischenteil hat dazu zwei Beine, die jeweils über ein Reibelement mit einem der Rotationselemente in Angriff sind.

Es ist Augabe der Erfindung, eine andere Antriebsvorrichtung der eingangs genannten Art zu schaffen, welche einen höheren Wirkungsgrad aufweist und eine flexibler Positionierung der Rotationselemente ermöglicht, und welche insbesondere für Rasierapparate geeignet sind.

Diese Aufgabe ist erfindungsgemäß dadurch gelöst, daß zwischen dem ersten Rotationselement und dem dritten Rotationselement ein zweites piezoelektrisches Antriebselement angeordnet und mittels einer Vorspannkraft eingespannt ist, das einen piezoelektrischen Resonator und wenigstens zwei an dem piezoelektrischen Resonator angeordnete und einander gegenüberliegende Reibelemente aufweist, wobei jeweils eines der Reibelemente des zweiten Antriebselementes gegen jeweils das erste oder das dritte Rotationselement drückt.

Mittels der elektrischen Mittel werden die piezoelektrischen Resonatoren und die an den piezoelektrischen Resonatoren befestigten Reibelemente zusammen zu einer Schwingung angeregt. Die schwingenden Reibelemente drücken in periodischer Abfolge gegen jeweils eines der Rotationselemente, wodurch eine Reibkraft zwischen den Rotationselementen und den Reibelementen auftritt. Infolge dieser Reibkraft werden die Rotationselemente gedreht. Die Vorspannkraft gewährleistet einen zuverlässigen Andruck der Reibelemente gegen die Rotationselemente.

Die piezoelektrischen Resonatoren wirken bei dieser Antriebsvorrichtung mittels der Reibelemente direkt auf die Rotationselemente ein. Es ist kein zusätzlicher Resonator erforderlich. Daher ist das benötigte Volumen für die piezoelektrischen Antriebselementen deutlich geringer als bei der Anordnung gemäß DE 35 00 607 C2. Der erreichbare Wirkungsgrad ist deutlich größer und liegt in der Größenordnung von 10%. Die Geometrie der piezoelektrischen Resonatoren ist vorzugsweise rechteckförmig. Dadurch läßt sie sich flexibel an unterschiedliche Achsabstände der Rotationselemente anpassen. Eine derartige Antriebsvorrichtung bietet dem Konstrukteur viele Freiheiten. Die Anzahl der Rotationselemente kann nahezu beliebig durch eine Änderung der Anzahl der verwendeten piezoelektrischen Antriebselemente erhöht werden.

Die Antriebsvorrichtung gemäß der Erfindung hat den Vorteil, daß mit nur zwei piezoelektrischen Antriebselementen drei Rotationselemente antreibbar sind. Dasjenige Rotationselement, das mit beiden piezoelektrischen Antriebselementen gekoppelt ist, weist ein höheres Drehmoment als die anderen beiden Rotationselemente auf Bei einem Einsatz in einem Rasierapparat ist dies jedoch kein Nachteil, da bei dieser Applikation die drei Rotationselemente nur gleiche Drehzahlen aufweisen müssen.

Unter Rotationselementen werden rotierbare Elemente, z.B. Antriebsachsen oder Antriebsräder verstanden.

Gemäß einer vorteilhaften Ausgestaltung der Erfindung ist zwischen dem zweiten Rotationselement und dem dritten Rotationselement ein drittes piezoelektrisches Antriebselement angeordnet und mittels einer Vorspannkraft eingespannt ist, das einen piezoelektrischen Resonator und wenigstens zwei an dem piezoelektrischen Resonator angeordnete und einander gegenüberliegende Reibelemente aufweist, wobei jeweils eines der Reibelemente des dritten Antriebselementes gegen jeweils das zweite oder das dritte Rotationselement drückt. Diese Ausgestaltung der Antriebsvorrichtung hat den Vorteil, daß die drei piezoelektrischen Antriebselemente und deren Antriebskräfte symmetrisch auf die drei Rotationselemente verteilt sind. Somit ist auch das Drehmoment der drei Rotationselemente gleich.

Gemäß einer vorteilhaften Ausgestaltung der Erfindung sind die piezoelektrischen Resonatoren als monomodaler Resonator ausgeführt. Der monomodale Resonator kann entweder ein Längsschwinger oder ein Biegeschwinger sein. Wird der monomodale Resonator als Längsschwinger ausgeführt und zwischen zwei Rotationselementen

angeordnet, so wird die Schwingungsachse des längsschwingenden Resonators vorzugsweise etwas gegenüber der Verbindungslinie der beiden Rotationselemente geneigt angeordnet, um eine zuverlässige Drehung der Rotationselemente zu gewährleisten. Die beiden Rotationselemente drehen sich dann in der gleichen Richtung.

Alternativ kann der monomodale Resonator auch als Biegeschwinger ausgeführt sein. Um eine zuverlässige Drehung der beiden Rotationselemente zu gewährleisten, wird der Biegeschwinger etwas parallel versetzt zu der Verbindungslinie der beiden Rotationselemente angeordnet. Die beiden Rotationselemente werden dann mittels der gegenüberliegenden Reibelemente des Biegeschwingers in entgegengesetzter Richtung angetrieben.

Gemäß der vorteilhaften Ausgestaltung der Erfindung nach Anspruch 4 werden die piezoelektrische Resonatoren als bimodaler Resonator ausgeführt. Einzelne Punkte des bimodalen Resonators können zweidimensionale kreisförmige oder elliptische Drehbewegungen ausführen. Die Richtung der Drehbewegung kann durch eine veränderte Schwingungsanregung mittels der elektrichen Anregungsmittel geändert werden. Somit läßt sich mittels des bimodalen Resonators die Drehrichtung der beiden Rotationselemente auf einfache Weise umkehren. Der bimodale Resonator ist vorzugsweise genau symmetrisch zwischen den beiden Rotationselementen angeordnet, wobei die Achse der Längsschwingung des bimodalen Resonators mit der Verbindungslinie zwischen den beiden Rotationselementen im wesentlichen übereinstimmt. Die Reibelemente des bimodalen Resonators führen ebenfalls elliptische oder kreisförmige Schwingungen aus und üben dabei jeweils eine einseitig gerichtete Reibkraft auf die Rotationselemente aus. Dadurch werden die beiden Rotationselemente in der gleichen Drehrichtung gedreht.

Gemäß Anspruch 7 ist die Antriebsvorrichtung vorzugsweise so ausgelegt, daß die Reibelemente eine elliptische Bewegung ausführen. Mittels einer elliptischen

Bewegung läßt sich eine besonders gute Reibkraft zwischen den Reibelementen und den Rotationselementen erzielen. Dies ist insbesondere dann der Fall, wenn die Längssymmetrieachse der Ellipse geneigt zu der Verbindungslinie zwischen den beiden Rotationselementen verläuft. Mittels der Längssymmetrieachse der Ellipse läßt sich die Hauptbewegungsrichtung der Reibelemente einstellen. Damit wird es möglich, die vorteilhafte Ausgestaltung der Erfindung gemäß Anspruch 8 zu realisieren. Gemäß dieser vorteilhaften Ausgestaltung der Erfindung entspricht die Hauptbewegungsrichtung der Reibungselemente, d.h. die Bewegungsrichtung in Richtung der Längssymmetrieachse der Ellipse, im wesentlichen dem Reibungswinkel der Materialien des jeweiligen Rotationselementes und des jeweiligen Reibungselementes. Damit läßt sich eine Haftreibung zwischen den Reibungselementen und den Rotationselementen erzielen und somit ein optimaler Wirkungsgrad der Antriebs Vorrichtung. Die höchste Haftreibungskraft läßt sich mittels der vorteilhaften Ausgestaltung nach Anspruch 9 realisieren. Ein besonders geeignetes Material mit einem Reibungswinkel von 28,8° ist Aluminiumoxid gemäß Anspruch 10.

Die vorteilhafte Ausgestaltung der Erfindung gemäß Anspruch 5 läßt sich sehr einfach und kostengünstig realisieren. Mittels der gegenüber der piezoelektrischen Platte hervortretenden Antriebsstößel wird eine Hubvergrößerung der Schwingung der Reibelemente erzielt. Die Polarisierrichtung ist unter allen vier Elektroden der ersten Oberfläche gleich. Vorzugsweise können gemäß Anspruch 6 die Resonanzfrequenzen der beiden orthogonalen Schwingungen des bimodalen Resonators einander so weit angenähert werden, daß mit einer elektrisch eingeprägten Betriebsfrequenz die beiden orthogonalen Schwingungen mit ausreichender Amplitude und gewünschter Phasenlage angeregt werden. Bei dieser vorteilhaften Ausgestaltung der Erfindung müssen nur zwei der vier Elektroden sowie die gemeinsame Masseelektrode gemäß Anspruch 5 mit einer Steuerelektronik gekoppelt werden. Die gesamte Steuerelektronik benötigt somit weniger Bauteile.

Vorzugsweise wird bei einer Antriebsvorrichtung gemäß Anspruch 11 eines der drei Rotationselemente in einem Festlager angeordnet, und die anderen beiden Rotationselemente werden in einem schwimmenden Lager angeordnet. Unter Festlager wird ein Lager verstanden, welches nicht verschiebbar an dem Gehäuse der Antriebsvorrichtung eingebaut ist. Die schwimmenden Lager sind dagegen verschiebbar in dem Gehäuse der Antriebsvorrichtung angeordnet, beispielsweise in einem Langloch. Dadurch wird es möglich, die schwimmenden Lager gegen die piezoelektrischen Antriebselemente zu verspannen, beispielsweise mittels einer Feder, die zwischen dem Gehäuse und dem schwimmenden Lager gespannt wird und deren Federkraft über das schwimmende Lager an das jeweilige piezoelektrische Antriebselement weitergeleitet wird.

Einige Ausführungsbeispiele der Erfindung werden anhand der Zeichnung in den Fig. 1 bis 7 näher erläutert. Es zeigen:
Fig. 1 eine schematisch dargestellte Antriebsvorrichtung für zwei Antriebsachsen, die ein Teil einer Antriebsvorrichtung für drei Antriebsachsen gemäß der Erfindung bildet, wobei zwischen den beiden Antriebsachsen ein bimodaler piezoelektrischer Resonator mittels einer Vorspannkraft eingespannt ist,
Fig. 2 eine Seitenansicht des piezoelektrischen Resonators gemäß Fig. 1,
Fig. 3 eine schematisch dargestellte Antriebsvorrichtung für zwei Antriebsachsen, die ein Teil einer Antriebsvorrichtung für drei Antriebsachsen gemäß der Erfindung bildet, wobei zwischen den zwei Antriebsachsen ein monomodaler längsschwingender piezoelektrischer Resonator eingespannt ist,
Fig. 4 eine Antriebsvorrichtung für zwei Antriebsachsen, die ein Teil einer Antriebsvorrichtung für drei Antriebsachsen gemäß der Erfindung bildet, wobei zwischen den zwei Antriebsachsen ein monomodaler biegeschwingender piezoelektrischer Resonator mittels einer Vorspannkraft eingespannt ist,
Fig. 5 eine Antriebsvorrichtung gemäß der Erfindung für drei Antriebsachsen, wobei zwei piezoelektrische Resonatoren jeweils zwischen zwei der drei Antriebsachsen mittels einer Vorspannkraft eingespannt sind,
Fig. 6 eine Antriebsvorrichtung gemäß der Erfindung für drei Antriebsachsen, wobei drei piezoelektrische Resonatoren jeweils zwischen zwei der drei Antriebsachsen mittels einer Vorspannkraft eingespannt sind,
Fig. 7 einen Rasierapparat mit drei Schneidmessern, welche dreieckförmig angeordnet und mittels jeweils einer Antriebsachse angetrieben werden, wobei für die drei Antriebsachsen eine Antriebsvorrichtung gemäß der Fig. 5 oder gemäß der Fig. 6 vorgesehen ist.

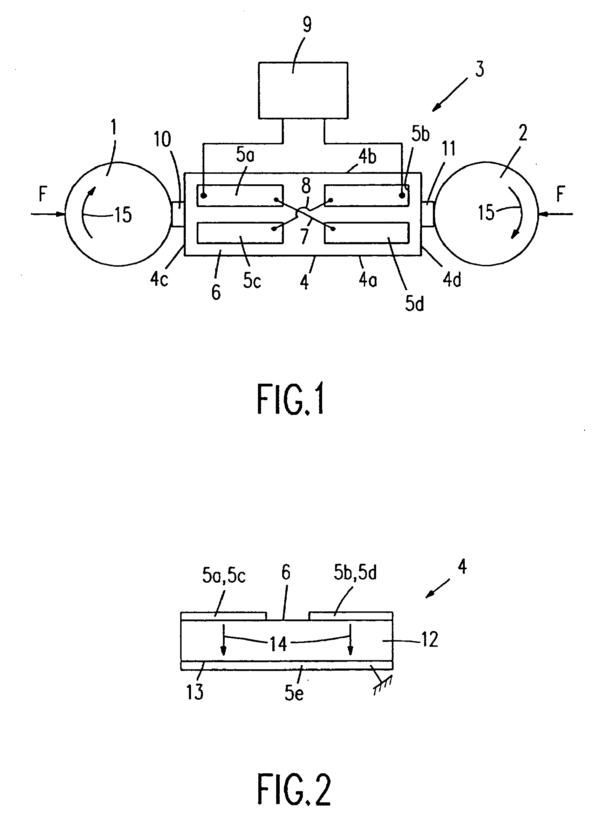

Fig. 1 zeigt eine Antriebsvorrichtung für zwei Rotationselemente. Als erstes Rotationselement ist eine erste Antriebsachse 1 und als zweites Rotationselement ist eine zweite Antriebsachse 2 vorgesehen. Die erste Antriebsachse 1 und die zweite Antriebsachse 2 sind beabstandet voneinander angeordnet. Zwischen der ersten Antriebsachse 1 und der zweiten Antriebsachse 2 ist ein piezoelektrisches Antriebselement 3 angeordnet. Das piezoelektrische Antriebselement 3 weist einen rechteckförmigen bimodalen piezoelektrischen Resonator 4 mit einer ersten Außenkante 4a, einer zweiten Außenkante 4b, einer dritten Außenkante 4c und einer vierten Außenkante 4d auf. Der piezoelektrische Resonator weist eine erste Elektrode 5a, eine zweite Elektrode 5b, eine dritte Elektrode 5c und eine vierte Elektrode 5d auf. Die vier Elektroden 5a, 5b, 5c und 5d sind auf eine erste Oberfläche 6 des piezoelektrischen Resonators 4 aufgebracht, beispielsweise mittels eines Siebdruckverfahrens. Die erste Elektrode 5a und die vierte Elektrode 5d sind mittels eines ersten Bonddrahtes 7 und die zweite Elektrode 5b und die dritte Elektrode 5c mittels eines zweiten Bonddrahtes 8 miteinander elektrisch verbunden. Die erste Elektrode 5a und die zweite Elektrode 5b sind mit einer elektrischen Steuereinheit 9 gekoppelt, mittels derer elektrische Signale zum Anregen einer Schwingung in dem piezoelektrischen Resonator 4 erzeugt werden. An der dritten Außenkante 4c ist mittig ein erster Antriebsstößel 10 befestigt, beispielsweise mittels einer Klebeverbindung. An der vierten Außenkante 5d ist mittig ein zweiter Antriebsstößel 11 befestigt, z.B. mittels einer Klebeverbindung. Der erste Antriebsstößel 10 und der zweite Antriebsstößel 11 bestehen vorzugsweise aus Aluminiumoxid.

Eine Seitenansicht des piezoelektrischen Resonators 4 ist in der Fig. 2 dargestellt. Der piezoelektrische Resonator 4 weist einen piezoelektrischen Grundkörper 12 mit der ersten Oberfläche 6 und einer zweiten Oberfläche 13 auf. Die zweite Oberfläche 13 ist vollständig mit einer Masseelektrode 5e bedeckt. Die Masselektrode 5e ist ebenfalls auf nicht näher dargestellte Weise mit der Steuereinheit 9 gekoppelt. Die Polarisierungsrichtung des piezoelektrischen Grundkörpers 12 ist unter den vier Elektroden 5a, 5b, 5c und 5d der ersten Oberfläche 6 gleich. In Fig. 2 ist die Polarisierungsrichtung durch zwei Pfeile 14 angedeutet.

Der piezoelektrische Resonator 4 mit dem daran befestigten ersten Antriebsstößel 10 und dem zweiten Antriebsstößel 11 ist gemäß Fig. 1 zwischen der ersten Antriebsachse 1 und der zweiten Antriebsachse 2 mittels einer Vorspannkraft F eingespannt. Infolge dieser Vorspannkraft F wird der erste Antriebsstößel 10 gegen die erste Antriebsachse 1 und der zweite Antriebsstößel 11 gegen die zweite Antriebsachse 2 gedrückt. Die erste Antriebsachse 1 und die zweite Antriebsachse 2 sind mit einer Schicht aus Aluminiumoxid überzogen. Mittels der Steuereinheit 9, welche elektrische Signale an die erste Elektrode 5a und die Masseelektrode 5e sendet, kann der piezoelektrische Resonator 4 zu einer bimodalen Schwingung angeregt werden. Die Vorspannkraft F, die Geometrie des piezoelektrischen Resonators 4 sowie die Reibkoeffizienten zwischen dem ersten Antriebsstößel 10 und der ersten Antriebsachse 1 sowie zwischen dem zweiten Antriebsstößel 11 und der zweiten Antriebsachse 2 sind derart dimensioniert, daß der piezoelektrische Resonator 4, der erste Antriebsstößel 10 bzw. der zweite Antriebsststößel 11 eine elliptische Drehbewegung ausführen. Dabei üben der erste Antriebsstößel 10 und der zweite Antriebsstößel 11 eine Reibkraft auf die erste Antriebsachse 1 bzw. die zweite Antriebsachse 2 aus, wodurch die erste Antriebsachse 1 und die zweite Antriebsachse 2 gedreht werden. Da die Drehrichtung der elliptischen Drehbewegung des ersten Antriebsstößels 10 und des zweiten Antriebsstößels 11 gleich ist, werden die erste Antriebsachse 1 und die zweite Antriebsachse 2 mittels des schwingenden piezoelektrischen Resonators 4 in der gleichen Drehrichtung angetrieben. In der Fig. 1 ist eine erste Drehrichtung 15 dargestellt.

Durch Anlegen der Steuersignale der ersten Steuereinheit 9 an die zweite Elektrode 5b und die Masseelektrode 5e läßt sich der piezoelektrische Resonator 4 auch zu einer elliptischen Schwingung anregen, die entgegengesetzt zu der in Fig. 1 dargestellten Schwingung gerichtet ist. Dementsprechend läßt sich mittels der Anordnung gemäß Fig. 1 auch eine entgegen der ersten Drehrichtung 15 gerichtete Drehung der Antriebsachsen erreichen. Eine Richtungsumkehr der Drehrichtung der ersten Antriebsachse 1 und der zweiten Antriebsachse 2 läßt sich somit allein mittels Änderung der Steuersignale der Steuereinheit 9 realisieren.

Der Reibungswinkel von Aluminiumoxid beträgt 28,8°. Die Vorspannkraft F, die Geometrie des piezoelektrischen Resonators 4 sind daher so dimensioniert, daß der erste Antriebsstößel 10 und der zweite Antriebsstößel 11 bei der elliptischen Drehbewegung im wesentlichen unter einem Winkel von 28,8° gegen die erste Antriebsachse 1 bzw. die zweite Antriebsachse 2 stoßen. Somit entspricht die Stoßrichtung des ersten Antriebsstößels 10 und des zweiten Antriebsstößels 11 im wesentlichen dem Reibungswinkel. Bei optimaler Ansteuerspannung tritt Haftreibung zwischen dem ersten Antriebsstößel 10 und der ersten Antriebsachse 1 sowie dem zweiten Antriebsstößel 11 und der zweiten Antriebsachse 2 auf und dies führt zu einer optimalen Geschwindigkeit. Dies gewährleistet einen guten Wirkungsgrad der Antriebsvorrichtung.

Die Drehzahl und das Drehmoment der ersten Antriebsachse 1 und der zweiten Antriebsachse 2 können über die Amplitude der von der ersten Steuereinheit 9 gelieferten elektrischen Spannung und über die Vorspannkraft F verändert bzw. eingestellt werden.

Der genauere Aufbau sowie die verschiedenen Möglichkeiten der elektrischen Anregung des piezoelektrischen Resonators 4 sind in der EP 633 616 A2 beschrieben, deren Inhalt durch diese ausdrückliche Bezugnahme in den Offenbarungsgehalt dieser Anmeldung aufgenommen wird.

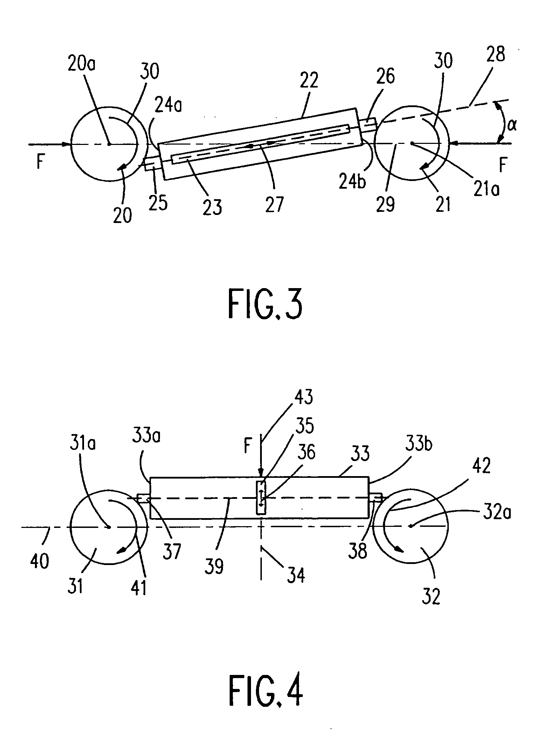

Fig. 3 zeigt eine Antriebsvorrichtung mit einer ersten Antriebsachse 20 und einer zweiten Antriebsachse 21. Zwischen der ersten Antriebsachse 20 und der zweiten Antriebsachse 21 ist ein monomodaler piezoelektrischer Resonator 22 angeordnet.

Der piezoelektrische Resonator 22 ist rechteckförmig und weist an der Oberseite eine erste Elektrode 23 sowie auf der Rückseite eine nicht näher dargestellte Masseelektrode auf. Die erste Elektrode 23 hat eine Form, die die Anregung von Längsschwingungen ermöglicht. Der piezoelektrische Resonator 22 ist als Längsschwinger ausgebildet. Der piezoelektrische Resonator 22 weist an seiner Stirnseite 24a einen ersten Antriebsstößel 25 sowie an der gegenüberliegenden Stirnseite 24b einen zweiten Antriebsstößel 26 auf. Der erste Antriebsstößel 25 und der zweite Antriebsstößel 26 sind an dem piezoelektrischen Resonator 22 mittels einer Klebeverbindung befestigt. Der piezoelektrische Resonator 22 wird mittels einer nicht näher dargestellten elektrischen Steuereinheit zu Längsschwingungen in Richtung des Doppelpfeiles 27 angeregt. Die Längssymmetrieachse 28 des piezoelektrischen Resonators 22 verläuft geneigt unter einem Winkel α zu der Verbindungslinie 29, welche die Mittelpunkte 20a und 21a der ersten Antriebsachse 20 und der zweiten Antriebsachse 21 verbindet. Der piezoelektrische Resonator 22 mit dem ersten Antriebsstößel 25 und dem zweiten Antriebsstößel 26 ist mittels einer Vorspannkraft F zwischen der ersten Antriebsachse 20 und der zweiten Antriebsachse 21 eingespannt. Im Schwingungsbetrieb üben der erste Antriebsstößel 25 und der zweite Antriebsstößel 26 Mikrostöße in Richtung des Doppelpfeiles 27 gegen die erste Antriebsachse 20 und die zweite Antriebsachse 21 aus, wodurch diese beide in der gleichen Drehrichtung 30 gedreht werden.

Fig. 4 zeigt eine Antriebsvorrichtung mit einer ersten Antriebsachse 31 und einer zweiten Antriebsachse 32. Die erste Achse 31 weist einen Mittelpunkt 31a und die zweite Achse 32 einen Mittelpunkt 32a auf. Zwischen der ersten Antriebsachse 31 und der zweiten Antriebsachse 32 ist ein rechteckförmiger piezoelektrischer Resonator 33 angeordnet. Der piezoelektrische Resonator 33 weist auf der Oberseite eine erste Elektrode 35 sowie auf der Unterseite eine nicht näher dargestellte Masseelektrode auf. Die erste Elektrode 35 hat eine Form, die die Anregung von Biegeschwingungen ermöglicht. Mittels einer nicht näher dargestellten Steuereinheit kann der piezoelektrische Resonator 33 zu Biegeschwingungen in Richtung des Doppelpfeiles 36 angeregt werden. Der piezoelektrische Resonator 33 weist an seiner Stirnseite 33a einen ersten Antriebsstößel 37 und an seiner Stirnseite 33b einen zweiten Antriebsstößel 38 auf. Die Längssymmetrieachse 39 des piezoelektrischen Resonators 33 ist parallel versetzt zu der Verbindungslinie 40 zwischen dem Mittelpunkt 31a der ersten Antriebsachse 31 und dem Mittelpunkt 32a der zweiten Antriebsachse 32 angeordnet.

Im Schwingungsbetrieb des piezoelektrischen Resonators 33 schwingt dieser zusammen mit dem ersten Antriebsstößel 37 und dem zweiten Antriebsstößel 38 in Richtung des Doppelpfeiles 36, wodurch der erste Antriebsstößel 37 Mikrostöße auf die erste Antriebsachse 31 und der zweite Antriebsstößel 38 Mikrostöße auf die zweite Antriebsachse 32 ausübt. Die erste Antriebsachse 31 wird dadurch in der ersten Drehrichtung 41 und die zweite Antriebsachse 32 in der entgegengesetzten Drehrichtung 42 gedreht.

Der piezoelektrische Resonator 33 ist mittels einer Vorspannkraft F in Richtung des Pfeiles 43 gegen die erste Antriebsachse 31 und die zweite Antriebsachse 32 verspannt.

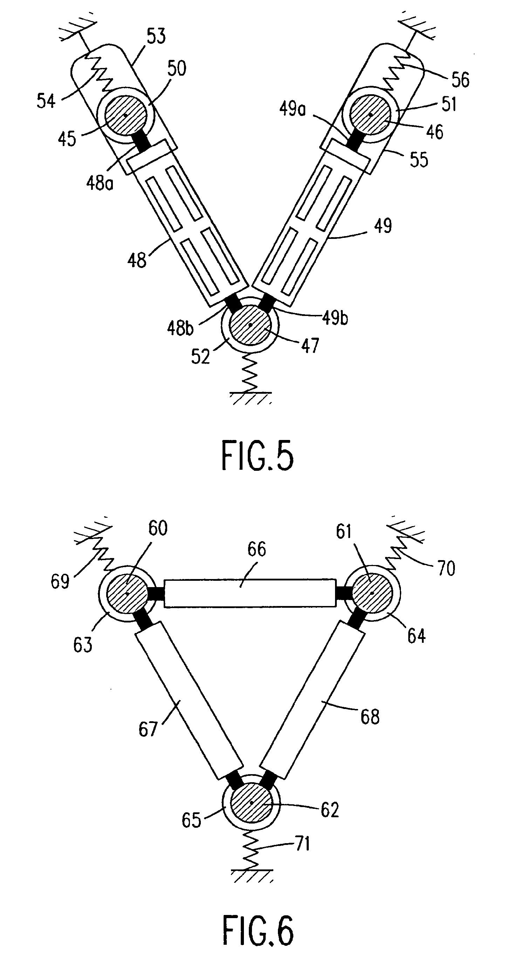

Fig. 5 zeigt eine Antriebsvorrichtung mit einer ersten Antriebsachse 45, einer zweiten Antriebsachse 46 und einer dritten Antriebsachse 47, welche dreieckförmig angeordnet sind. Zwischen der ersten Antriebsachse 45 und der dritten Antriebsachse 47 ist ein erster piezoelektrischer Resonator 48 und zwischen der zweiten Antriebsachse 46 und der dritten Antriebsachse 47 ein zweiter piezoelektrischer Resonator 49 angeordnet. Der erste piezoelektrische Resonator 48 und der zweite piezoelektrische Resonator 49 sind als bimodale pizoelektrische Resonatoren entsprechend der in der Fig. 1 beschriebenen Ausführung ausgeführt. Die erste Antriebsachse 45 ist in einem ersten schwimmenden Lager 50, die zweite Antriebsachse 46 in einem zweiten schwimmenden Lager 51 und die dritte Antriebsachse 47 in einem Festlager 52 gelagert. Das erste schwimmende Lager 50 ist in einem Langloch 53 bewegbar gelagert und mittels einer Feder 54 in Richtung auf den ersten piezoelektrischen Resonator 48 verspannt. Das Langloch 53 befindet sich in einem nicht näher dargestellten Gehäuse der Antriebsvorrichtung. Das zweite schwimmende Lager 51 ist in einem Langloch 55 verschiebbar gelagert und mittels einer Feder 56 in Richtung auf den zweiten piezoelektrischen Resonator 49 verspannt. Das Festlager 52 ist fest an dem nicht näher dargestellten Gehäuse befestigt. Der erste piezoelektrische Resonator 48 weist einen ersten Antriebsstößel 48a auf, der an der ersten Antriebsachse 45 anliegt, und einen zweiten Antriebsstößel 48b, der an der dritten Antriebsachse 47 anliegt. Der zweite piezoelektrische Resonator 49 weist einen ersten Antriebsstößel 49a, der an der zweiten Antriebsachse 46 anliegt, und einen zweiten Antriebsstößel 49b, der an der dritten Antriebsachse 47 anliegt.

Die erste Antriebsachse 45 wird somit federnd mittels der Federkraft der Feder 54 gegen das erste piezoelektrische Element 48 gedrückt, wodurch das erste piezoelektrische Element 48 federnd zwischen der ersten Antriebsachse 45 und der dritten Antriebsachse 47 eingespannt ist. In entsprechender Weise ist der zweite piezoelektrische Resonator 49 mittels der Feder 56 federnd zwischen der zweiten Antriebsachse 46 und der dritten Antriebsachse 47 eingespannt.

Der erste piezoelektrische Resonator 48 und der zweite piezoelektrische Resonator 49 können mittels einer nicht näher dargestellten Steuereinheit zu elliptischen Schwingungen angeregt werden, wodurch die Antriebsstößel 48a, 48b, 49a und 49b eine Reibkraft auf die erste Antriebsachse 45, die zweite Antriebsachse 46 und die dritte Antriebsachse 47 ausüben. Die Drehrichtung der drei Antriebsachsen 45, 46 und 47 ist gleich und kann mittels der in der Fig. 5 nicht dargestellten Steuereinheit, wie zu Fig. 1 beschrieben, umgekehrt werden.

Die Drehgeschwindigkeit der drei Antriebsachsen 45, 46 und 47 ist im wesentlichen gleich. Da auf die dritte Antriebsachse 47 sowohl der erste piezoelektrische Resonator 48 als auch der zweite piezoelektrische Resonator 49 einwirkt, ist das verfügbare Drehmoment der dritten Antriebsachse 47 größer als das verfügbare Drehmoment der ersten Antriebsachse 45 und der zweiten Antriebsachse 46.

Fig. 6 zeigt eine Antriebsvorrichtung mit einer ersten Antriebsachse 60, einer zweiten Antriebsachse 61 und einer dritten Antriebsachse 62, welche dreieckförmig angeordnet sind. Die erste Antriebsachse 60 ist in einem schwimmenden Lager 63, die zweite Antriebsachse 61 in einem schwimmenden Lager 64 und die dritte Antriebsachse 62 in einem schwimmenden Lager 65 gelagert. Zwischen der ersten Antriebsachse 60 und der zweiten Antriebsachse 61 ist ein erster piezoelektrischer Resonator 66 angeordnet. Zwischen der ersten Antriebsachse 60 und der dritten Antriebsachse 62 ist ein zweiter piezoelektrischer Resonator 67 angeordnet. Zwischen der zweiten Antriebsachse 61 und der dritten Antriebsachse 62 ist ein dritter piezoelektrischer Resonator 68 angeordnet. Der erste piezoelektrische Resonator 66, der zweite piezoelektrische Resonator 67 und der dritte piezoelektrische Resonator 68 sind jeweils als bimodale piezoelektrische Resonatoren entsprechend der in der Fig. 1 beschriebenen Ausführungsart ausgeführt. Das schwimmende Lager 63 ist mittels einer Feder 69 gegen ein nicht näher dargestelltes Gehäuse vorgespannt. Das schwimmende Lager 64 ist mittels einer Feder 70 gegen das nicht näher dargestellte Gehäuse vorgespannt, und das schwimmende Lager 65 ist mittels einer Feder 71 gegen das nicht näher dargestellte Gehäuse vorgespannt. Somit ist der erste piezoelektrische Resonator 66 federnd zwischen der ersten Antriebsachse 60 und der zweiten Antriebsachse 61 eingespannt, der zweite piezoelektrische Resonator 67 ist federnd zwischen der ersten Antriebsachse 60 und der dritten Antriebsachse 62 eingespannt, und der dritte piezoelektrische Resonator 68 ist federnd zwischen der zweiten Antriebsachse 61 und der dritten Antriebsachse 62 eingespannt. Die drei piezoelektrischen Resonatoren 66, 67 und 68 können mittels einer nicht näher dargestellten Steuereinheit, wie zu Fig. 1 beschrieben, zu elliptischen Schwingungen angeregt werden, wodurch die erste Antriebsachse 60, die zweite Antriebsachse 61 und die dritte Antriebsachse 62 in der gleichen Drehrichtung angetrieben werden. Eine Drehrichtungsumkehr ist mittels der elektrischen Ansteuerung einfach zu realisieren. Infolge der vollständigen symmetrischen Anordnung der Antriebsvorrichtung gemäß Fig. 6 ist sowohl das verfügbare Drehmoment als auch die Drehzahl der drei Antriebsachsen 60, 61 und 62 gleich.

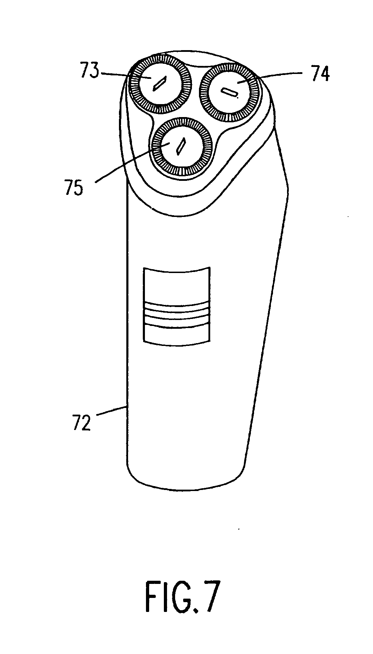

Fig. 7 zeigt einen Rasierapparat 72 mit einem ersten Scherkopf 73, einem zweiten Scherkopf 74 und einem dritten Scherkopf 75. Der erste Scherkopf 73, der zweite Scherkopf 74 und der dritte Scherkopf 75 werden mittels einer Antriebsvorrichtung gemäß Fig. 5 oder einer Antriebsvorrichtung gemäß Fig. 6 angetrieben.

## Patentansprüche

1. Antriebsvorrichtung mit einem ersten Rotationselement, einem zweiten Rotationselement und einem dritten Rotationselement, die dreieckförmig angeordnet sind, wobei zwischen dem ersten Rotationselement und dem zweiten Rotationselement ein erstes piezoelektrisches Antriebselement angeordnet und mittels einer Vorspannkraft eingespannt ist, das einen piezoelektrischen Resonator und wenigstens zwei an dem piezoelektrischen Resonator angeordnete und einander gegenüberliegende Reibelemente aufweist, wobei jeweils eines der Reibelemente des ersten Antriebselementes gegen jeweils das erste oder das zweite Rotationselement drückt, und wobei elektrische Mittel zum Anregen einer Schwingung des piezoelektrischen Resonators vorgesehen sind, **dadurch gekennzeichnet, daß** zwischen dem ersten Rotationselement und dem dritten Rotationselement ein zweites piezoelektrisches Antriebselement angeordnet und mittels einer Vorspannkraft eingespannt ist, das einen piezoelektrischen Resonator und wenigstens zwei an dem piezoelektrischen Resonator angeordnete und einander gegenüberliegende Reibelemente aufweist, wobei jeweils eines der Reibelemente des zweiten Antriebselementes gegen jeweils das erste oder das dritte Rotationselement drückt.

2. Antriebsvorrichtung nach Anspruch 1, **dadurch gekennzeichnet, daß** zwischen dem zweiten Rotationselement und dem dritten Rotationselement ein drittes piezoelektrisches Antriebselement angeordnet und mittels einer Vorspannkraft eingespannt ist, das einen piezoelektrischen Resonator und wenigstens zwei an dem piezoelektrischen Resonator angeordnete und einander gegenüberliegende Reibelemente aufweist, wobei jeweils eines der Reibelemente des dritten Antriebselementes gegen jeweils das zweite oder das dritte Rotationselement drückt.

3. Antriebsvorrichtung nach Anspruch 1, **dadurch gekennzeichnet, daß** die piezoelektrische Resonatoren als monomodale Resonatoren ausgeführt sind.

4. Antriebsvorrichtung nach Anspruch 1, **dadurch gekennzeichnet, daß** die piezoelektrische Resonatoren als bimodale Resonatoren ausgeführt sind.

5. Antriebsvorrichtung nach Anspruch 4, **dadurch gekennzeichnet, daß** die piezoelektrische Antriebselemente eine im wesentlichen rechteckförmige piezoelektrische Platte mit einer ersten Oberfläche und einer zweiten Oberfläche aufweisen, daß die erste Oberfläche wenigstens vier Elektroden und die zweite Oberfläche wenigstens eine Elektrode aufweist, daß in jedem Quadranten der ersten Oberfläche jeweils eine Elektrode angeordnet ist und daß die Reibelemente als gegenüber der piezoelektrischen Platte hervortretende Antriebsstößel ausgebildet sind.

6. Antriebsvorrichtung nach Anspruch 4, **dadurch gekennzeichnet, daß** die Geometrie der piezoelektrischen Resonatoren derart gewählt ist, daß die beiden Resonanzfrequenzen des piezoelektrischen Resonators so nahe beieinander liegen, daß bei elektrischer Anregung der einen Resonanzfrequenz die andere Resonanzfrequenz mitangeregt wird.

7. Antriebsvorrichtung nach Anspruch 4, **dadurch gekennzeichnet, daß** die Vorspannkraft, die Geometrie der piezoelektrischen Resonatoren und die Reibkoeffizienten zwischen den Reibelementen und den Rotationselementen derart dimensioniert sind, daß die Reibelemente eine im wesentlichen elliptische Bewegung ausführen, wobei die Längssymmetrieachse der Ellipse geneigt zu der Verbindungslinie zwischen den beiden bezüglichen Rotationselementen verläuft.

8. Antriebsvorrichtung nach Anspruch 7, **dadurch gekennzeichnet, daß** die Vorspannkraft, die Geometrie der piezoelektrischen Resonatoren und die Reibkoeffizienten zwischen den Reibelementen und den Rotationselementen derart dimensioniert sind, daß die Hauptbewegungsrichtung der Reibungselemente im wesentlichen dem Reibungswinkel zwischen den Rotationselemente und den Reibungselementen entspricht.

9. Antriebsvorrichtung nach Anspruch 1, **dadurch gekennzeichnet, daß** die Materialien der Rotationselemente und der Reibungselemente so gewählt sind, daß der Reibungswinkel in einem Bereich zwischen 15° und 35 ° liegt.

10. Antriebsvorrichtung nach Anspruch 1, **dadurch gekennzeichnet, daß** die Reibelemente und/oder die Oberflächen der Rotationselemente aus Aluminiumoxid bestehen.

11. Antriebs vorrichtung nach Anspruch 1, **dadurch gekennzeichnet, daß** eines der drei Rotationselemente in einem Festlager und die anderen beiden Rotationselemente in jeweils einem schwimmenden Lager angeordnet sind, daß die beiden piezoelektrischen Antriebselemente jeweils zwischen dem in dem Festlager angeordneten Rotationelement und einem der in den schwimmenden Lagern angeordneten Rotationselemente angeordnet sind und daß die schwimmenden Lager gegen das jeweilige piezoelektrische Antriebselement mittels einer Vorspannkraft vorgespannt sind.

12. Antriebsvorrichtung nach Anspruch 5, **dadurch gekennzeichnet, daß** das Längen-Breiten-Verhältnis der piezoelektrischen Platte in einem Bereich zwischen 1:3 und 1:4 liegt.

13. Rasierapparat mit einer Antriebsvorrichtung nach Anspruch 1.

14. Elektrisches Haushaltsgerät mit einer Antriebsvorrichtung nach Anspruch 1.

## Claims

1. A drive device with a first rotation element, a second rotation element, and a third rotation element which are arranged in a triangle, wherein a first piezoelectric drive element is arranged between the first and the second rotation element and is tensioned by a bias force, which first piezoelectric drive element comprises a piezoelectric resonator and at least two friction elements that are arranged against the piezoelectric resonator and are arranged in mutual opposition, such that one of the friction elements of said first drive element presses against either the first or the second rotation element at any one time, and wherein electrical means are provided for generating a vibration of the piezoelectric resonator, **characterized in that** a second piezoelectric drive element is arranged between the first and the third rotation element and is tensioned by a bias force, which second piezoelectric drive element comprises a piezoelectric resonator and at least two friction elements that are arranged against the piezoelectric resonator and are arranged in mutual opposition, such that one of the friction elements of said second drive element presses against either the first or the third rotation element at any one time.

2. A drive device as claimed in claim 1, **characterized in that** a third piezoelectric drive element is arranged between the second and the third rotation element and is tensioned by a bias force, which third piezoelectric drive element comprises a piezoelectric resonator and at least two friction elements that are arranged against the piezoelectric resonator and are arranged in mutual opposition, such that one of the friction elements of said third drive element presses against either the second or the third rotation element at any one time.

3. A drive device as claimed in claim 1, **characterized in that** the piezoelectric resonators are constructed as monomode resonators.

4. A drive device as claimed in claim 1, **characterized in that** the piezoelectric resonators are constructed as dual-mode resonators.

5. A drive device as claimed in claim 4, **characterized in that** the piezoelectric drive elements each comprise a substantially rectangular piezoelectric plate with a first surface and a second surface, **in that** said first surface comprises at least four electrodes and said second surface comprises at least one electrode, **in that** one electrode is located in each quadrant of the first surface, and **in that** the friction elements are constructed as raised drive studs that project opposite the piezoelectric plate.

6. A drive device as claimed in claim 4, **characterized in that** the geometry of the piezoelectric resonators is chosen such that the two resonance frequencies of the piezoelectric resonator lie so close together that in the event of an excitation of one of the resonance frequencies the other resonance frequency is also excited.

7. A drive device as claimed in claim 4, **characterized in that** the bias force, the geometry of the piezoelectric resonators, and the friction coefficients obtaining between the friction elements and the rotation elements are so dimensioned that the friction elements perform a substantially elliptical motion wherein the longitudinal axis of symmetry of the ellipse extends obliquely with respect to the connecting line between the two rotation elements in question.

8. A drive device as claimed in claim 7, **characterized in that** the bias force, the geometry of the piezoelectric resonators, and the friction coefficients obtaining between the friction elements and the rotation elements are so dimensioned that the main direction of movement of the friction elements corresponds substantially to the friction angle between the rotation elements and the friction elements.

9. A drive device as claimed in claim 1, **characterized in that** the materials of the rotation elements and of the friction elements are chosen such that the friction angle lies in a range of between 15° and 35°.

10. A drive device as claimed in claim 1, **characterized in that** the friction elements and/or the surfaces of the rotation elements are made of aluminum oxide.

11. A drive device as claimed in claim 1, **characterized in that** one of the three rotation elements is held in a fixed bearing and the other two rotation elements are each given a floating mounting, **in that** the two piezoelectric drive elements are each arranged between the rotation element held in the fixed bearing and one of the rotation elements having a floating mounting, and **in that** the floating mountings are biased by a bias force against the respective piezoelectric drive element.

12. A drive device as claimed in claim 5, **characterized in that** the length/width ratio of the piezoelectric plate lies in a range of between 1:3 and 1:4.

13. A shaving apparatus comprising a drive device as claimed in claim 1.

14. An electrical domestic appliance comprising a drive device as claimed in claim 1.

## Revendications

1. Dispositif d'entraînement avec un premier élément de rotation, un deuxième élément de rotation et un troisième élément de rotation, qui sont agencés en forme de triangle, dans lequel un premier élément d'entraînement piézoélectrique est agencé entre le premier élément de rotation et le deuxième élément de rotation et serré au moyen d'une force de précontrainte, lequel présente un résonateur piézoélectrique et au moins deux éléments de frottement se faisant face l'un l'autre et agencés au niveau du résonateur piézoélectrique, dans lequel respectivement un des éléments de frottement du premier élément d'entraînement appuie contre respectivement le premier ou le deuxième élément de rotation, et dans lequel des moyens électriques sont prévus pour activer une oscillation du résonateur piézoélectrique, **caractérisé en ce qu'**un deuxième élément d'entraînement piézoélectrique est agencé entre le premier élément de rotation et le troisième élément de rotation et serré au moyen d'une force de précontrainte, lequel présente un résonateur piézoélectrique et au moins deux éléments de frottement se faisant face l'un l'autre et agencés au niveau du résonateur piézoélectrique, dans lequel respectivement un des éléments de frottement du deuxième élément d'entraînement appuie contre respectivement le premier ou le troisième élément de rotation.

2. Dispositif d'entraînement selon la revendication 1, **caractérisé en ce qu'**un troisième élément d'entraînement piézoélectrique est agencé entre le deuxième élément de rotation et le troisième élément de rotation et serré au moyen d'une force de précontrainte, lequel présente un résonateur piézoélectrique et au moins deux éléments de frottement se faisant face l'un l'autre et agencés au niveau du résonateur piézoélectrique, dans lequel respectivement un des éléments de frottement du troisième élément d'entraînement appuie contre respectivement le deuxième ou le troisième élément de rotation.

3. Dispositif d'entraînement selon la revendication 1, **caractérisé en ce que** les résonateurs piézoélectriques sont réalisés sous forme de résonateurs monomode.

4. Dispositif d'entraînement selon la revendication 1, **caractérisé en ce que** les résonateurs piézoélectriques sont réalisés sous forme de résonateurs bimode.

5. Dispositif d'entraînement selon la revendication 4, **caractérisé en ce que** les éléments d'entraînement piézoélectriques présentent une plaque piézoélectrique essentiellement rectangulaire avec une première surface et une deuxième surface, **en ce que** la première surface présente au moins quatre électrodes et la deuxième surface présente au moins une électrode, **en ce que** respectivement une électrode est agencée dans chaque quadrant de la première surface et **en ce que** les éléments de frottement sont réalisés sous forme de poussoir d'entraînement en saillie par rapport à la plaque piézoélectrique.

6. Dispositif d'entraînement selon la revendication 4, **caractérisé en ce que** la géométrie des résonateurs piézoélectriques est sélectionnée de telle sorte que les deux fréquences de résonance du résonateur piézoélectrique sont si proches les unes des autres que lors d'une excitation électrique l'une des fréquences de résonance excite l'autre fréquence de résonance.

7. Dispositif d'entraînement selon la revendication 4, **caractérisé en ce que** la force de précontrainte, la géométrie des résonateurs piézoélectriques et les coefficients de frottement entre les éléments de frottement et les éléments de rotation sont dimensionnés de telle sorte que les éléments de frottement réalisent un mouvement essentiellement elliptique, l'axe de symétrie longitudinal de l'ellipse s'étendant de manière inclinée vers la ligne de jonction entre les deux éléments de rotation s'y rapportant.

8. Dispositif d'entraînement selon la revendication 7, **caractérisé en ce que** la force de précontrainte, la géométrie des résonateurs piézoélectriques et les coefficients de frottement entre les éléments de frottement et les éléments de rotation sont dimensionnés de telle sorte que le sens de déplacement principal des éléments de frottement correspond essentiellement à l'angle de frottement entre les éléments de rotation et les éléments de frottement.

9. Dispositif d'entraînement selon la revendication 1, **caractérisé en ce que** les matériaux des éléments de rotation et des éléments de frottement sont sélectionnés de telle sorte que l'angle de frottement se trouve dans une plage comprise entre 15° et 35°.

10. Dispositif d'entraînement selon la revendication 1, **caractérisé en ce que** les éléments de frottement et/ou les surfaces des éléments de rotation sont en oxyde d'aluminium.

11. Dispositif d'entraînement selon la revendication 1, **caractérisé en ce qu'**un des trois éléments de rotation est agencé dans un palier fixe et les deux autres éléments de rotation sont agencés respectivement dans un palier flottant, **en ce que** les deux éléments d'entraînement piézoélectriques sont agencés respectivement entre l'élément de rotation agencé dans le palier fixe et un des éléments de rotation agencés dans les paliers flottants et **en ce que** les paliers flottants sont précontraints contre l'élément d'entraînement piézoélectrique respectif au moyen d'une force de précontrainte.

12. Dispositif d'entraînement selon la revendication 5, **caractérisé en ce que** le rapport longueur-largeur de la plaque piézoélectrique se trouve dans une plage comprise entre 1:3 et 1:4.

13. Rasoir avec un dispositif d'entraînement selon la revendication 1.

14. Appareil électroménager avec un dispositif d'entraînement selon la revendication 1.
